(19) Europäisches Patentamt
European Patent Office
Office européen des brevets

(11) EP 0 737 389 B1

(12) EUROPÄISCHE PATENTSCHRIFT

(45) Veröffentlichungstag und Bekanntmachung des Hinweises auf die Patenterteilung:
13.08.2003 Patentblatt 2003/33

(51) Int Cl.⁷: **H04L 1/00**, H03M 13/00

(21) Anmeldenummer: 95933587.8

(22) Anmeldetag: 24.10.1995

(86) Internationale Anmeldenummer:
PCT/IB95/00912

(87) Internationale Veröffentlichungsnummer:
WO 96/013105 (02.05.1996 Gazette 1996/20)

(54) **ÜBERTRAGUNGSSYSTEM MIT SOFT-OUTPUT-DEKODIERUNG BEI REDUZIERTEM SPEICHERBEDARF**

TRANSMISSION SYSTEM WITH SOFT OUTPUT DECODING AND REDUCED STORAGE CAPACITY REQUIREMENT

SYSTEME DE TRANSMISSION AVEC DECODAGE "SOFT-OUTPUT" ET DEMANDE EN CAPACITE MEMOIRE REDUITE

(84) Benannte Vertragsstaaten:
**DE FR GB IT**

(30) Priorität: 25.10.1994 DE 4437984

(43) Veröffentlichungstag der Anmeldung:
16.10.1996 Patentblatt 1996/42

(73) Patentinhaber:
• **Koninklijke Philips Electronics N.V.**
**5621 BA Eindhoven (NL)**
• **Philips Intellectual Property & Standards GmbH**
**20099 Hamburg (DE)**
Benannte Vertragsstaaten:
**DE**

(72) Erfinder: PETERSEN, Jürgen
D-90491 Nürnberg (DE)

(74) Vertreter: Volmer, Georg, Dipl.-Ing. et al
Philips Intellectual Property & Standards GmbH,
Postfach 50 04 42
52088 Aachen (DE)

(56) Entgegenhaltungen:
EP-A- 0 391 354          DE-A- 4 224 214

• JOURNAL OF VLSI SIGNAL PROCESSING, Bd.8, Nr.2, Oktober 1994, DORDRECHT NL Seiten 169 - 180, XP483302 O. J. JOERESSEN / M. VAUPEL / H. MEYR: 'High-Speed VLSI Architectures for Soft-Output Viterbi Decoding.'
• ICASSP-93. 1993 INTERNATIONAL CONFERENCE ON ACOUSTICS, SPEECH AND SIGNAL PROCESSING, MINNEAPOLIS, US, 27.-30.04.1993, Bd.1, 27. April 1993, IEEE, NEW YORK, US Seiten 433 - 436, XP398410 P. J. BLACK / T. H.-Y. MENG: 'Hybrid Survivor Path Architectures for Viterbi Decoders.'
• IEEE TRANSACTIONS ON INFORMATION THEORY, Bd.IT-20, Nr.2, März 1974, NEW YORK US Seiten 284 - 287 L. R. BAHL / J. COCKE / F. JELINK / J. RAVIV: 'Optimal Decoding of Linear Codes for Minimizing Symbol Error Rate.'
• IEEE INTERNATIONAL CONFERENCE ON COMMUNICATIONS. ICC'89, BOSTON, US, 11.-14.06.1989, Bd.2, 11. Juni 1989, IEEE, NEW YORK, US Seiten 1096 - 1100, XP75285 H. K. THAPAR / J. M. CIOFFI: 'A Block Processing Method for Designing High-Speed Viterbi Detector.'
• IEEE TRANSACTIONS ON INFORMATION THEORY, Bd.41, Nr.3, Mai 1995, NEW YORK US Seiten 704 - 713 Y. LI / B. VUCETIC / Y. SATO: 'Optimum Soft-Output Detection for Channels with Intersymbol Interference.'

**Beschreibung**

Die Erfindung betrifft ein digitales Übertragungssystem mit einer eine Codiereinrichtung zur Codierung eines zu übertragenden Digitalsignals aufweisenden Sendeeinrichtung, mit mindestens einem Übertragungskanal zur Übertragung des codierten Digitalsignals und mit einer Decodiereinrichtung zur Bildung eines decodierten Digitalsignal mit einem den jeweiligen Symbolen des decodierten Digitalsignals zugeordneten Schätzwert für die Wahrscheinlichkeit mit der das jeweilige Symbol gesendet wurde, wobei zur Ermittlung der Schätzwerte Vorwärtsund abzuspeichernde Rückwärtszustandsmetriken vorgesehen sind.

Die Erfindung betrifft weiter eine Funkstation, insbesondere eine Feststation- oder eine Mobilstation mit einer Decodiereinrichtung zur Bildung eines decodierten Digitalsignal aus einem Empfangssignal mit einem den jeweiligen Symbolen des decodierten Digitalsignals zugeordneten Schätzwert für die Wahrscheinlichkeit. mit der das jeweilige Symbol gesendet wurde, wobei zur Ermittlung der Schätzwerte Vorwärts- und abzuspeichernde Rückwärtszustandsmetriken vorgesehen sind.

Die Erfindung betrifft weiter eine Decodiereinrichtung für eine derartige Funkstation.

Die Erfindung ist bei der Decodierung von Faltungscodes mit Soft-Input- und Soft-Output-Werten nach dem Prinzip des Symbol-by-Symbol MAP-Algorithmus (MAP= maximum a-posteriori probability) einsetzbar. Dabei wird die a-Posteriori-Wahrscheinlichkeit für die decodierten Symbole maximiert unter der Bedingung der empfangenen Folge. Der Symbol-by-Symbol MAP-Decodieralgorithmus kann durch Anwendung einer Vorwärts- und Rückwärtsrekursion durch das Trellis-Diagramm des Faltungscodes realisiert werden. Dabei sind sowohl die Vorwärts- und bis auf die Rekursionsrichtung auch die Rückwärtsrekursion dem Viterbi-Algorithmus sehr ähnlich. Die bei der Rückwärtsrekursion berechneten akkumulierten Metriken müssen abgespeichert werden, da sie bei der Vorwärtsrekursion für die Berechnung der Soft-Output-Werte benötigt werden. Der Speicherplatzbedarf beträgt hierfür $N \cdot 2^{L-1}$ Worte (Auf heute üblichen Festkomma-DSP's besteht ein Wort in der Regel aus 16 Bits), wobei N die Blocklänge und L die Einflußlänge des Faltungscodes ist Typische Werte für L liegen im Bereich [5, ... ,7]. Das bedeutet bereits bei moderaten Blocklängen N von einigen hundert Bits einen hohen Speicherplatzbedarf, der auf heute verfügbaren Digitalen Signalprozessoren (DSP) nicht zur Verfügung gestellt werden kann. Wegen der Rückwärtsrekursion und der Abspeicherung der Metriken ist der Algorithmus primär für Signalfolgen mit Blockstruktur geeignet.

Der exakte Symbol-by-Symbol MAP-Algorithmus ist für Festkomma-DSP's grundsätzlich ungeeignet, da er als Soft-Input-Werte Wahrscheinlichkeiten benötigt, deren Verknüpfung im Algorithmus (Multiplikation und Addition) schnell zu numerischen Problemen führt. Daher muß auf heute verfügbaren Festkomma-DSP's eine suboptimale Variante eingesetzt werden, die als Soft-Input-Werte entweder logarithmierte Wahrscheinlichkeiten oder sog. Log-Likelihood-Verhältniswerte verwendet, wobei die Verknüpfungen im Algorithmus dann aus Additionen und Maximumbildung bestehen.

Der Erfindung liegt die Aufgabe zugrunde, ein Übertragungssystem der eingangs genannten Art mit einem reduzierten Speicherbedarf der Decodiereinrichtung anzugeben.

Diese Aufgabe wird gemäß den Ansprüchen 1 und 7 bei einem Übertragungssystem bzw. bei einer Funkstation der eingangs genannten Art dadurch gelöst, daß die Decodiereinrichtung Mittel zur Speicherung der Rückwärtszustandsmetriken nur in jedem L-ten Schritt aufweist, wobei L die Einflußlänge des in der Decodiereinrichtung verwendeten Faltungscodes ist.

Bei einer Funkstation und einer Decodiereinrichtung der eingangs genannten Art wird diese Aufgabe dadurch gelöst, daß die Decodiereinrichtung Mittel zur Speicherung der Rückwärtszustandsmetriken nur in jedem L-ten Schritt aufweist, wobei L die Einflußlänge des in der Decodiereinrichtung verwendeten Faltungscodes ist.

Die Erfindung besteht darin, durch Modifikation des bereits bekannten Basis-Algorithmus den erforderlichen Speicherplatzbedarf für die akkumulierten Metriken aus der Rückwärtsrekursion um den Faktor L zu reduzieren. Das gilt sowohl für den exakten als auch für den suboptimalen Algorithmus. Für den suboptimalen Algorithmus kann man eine weitere Einsparung sowohl an Speicherplatzbedarf als auch an Rechenaufwand erreichen, wenn nur für einen Teil der Bits eines Blockes Soft-Output-Werte erforderlich sind. Diese Bits können dann durch Umsortierung an den Anfang und/oder an das Ende eines Blockes plaziert werden, so daß dann die Möglichkeit besteht, den vollständigen Soft-Output-Algorithmus nur auf diese Bits zu beschränken. Für die übrigen Bits kann die Abspeicherung der akkumulierten Metriken aus der Rückwärtsrekursion und auch die Rückwärtsrekursion selbst entfallen. Statt dessen muß für diese Bits ein "Survivor"- oder Pfad-Gedächtnis während der Vorwärtsrekursion geführt werden, was dem herkömmlichen Viterbi-Algorithmus entspricht und lediglich $N \cdot 2^{L-1}/16$ Worte an Speicherplatz beansprucht.

Die Erfindung geht von einem Übertragungssystem aus. das aus den Komponenten Binärquelle, Faltungsencoder, Kanal und Faltungsdecoder besteht. Insbesondere soll der Kanal neben den sende- und empfangsseitigen Komponenten wie Modulator und Demodulator zusätzlich eine Einrichtung enthalten. die die Wahrscheinlichkeiten $P(\hat{u}_{nm})$ schätzt, mit der die Symbole $\hat{u}_{nm}$ gesendet wurden, oder eine daraus abgeleitete Größe wie logarithmierte Wahrscheinlichkeiten $\log P(\hat{u}_{nm})$ bzw. Log-Likelihood-Verhältniswerte $\log(P(\hat{u}_{nm} = 1)/P(\hat{u}_{nm} = 0))$.

Die Binärquelle erzeugt binäre Vektoren $\underline{x} = (x_1, x_2, ... , x_{N-L+1}, x_{N-L+2}=0, ... , x_N=0)$ der Länge N mit $x_i \in \{0, 1\}$, wobei jeweils die letzten L-1 Bits mit Nullen besetzt werden (Tail-Bits), damit der Encoder und Decoder nach jedem Block in den Nullzustand übergehen. Der Faltungsencoder generiert aus jedem Eingabesymbol $x_n$ ein Ausgabesymbol $u_n = (u_{n1}, \ldots, u_{nM})$ der Länge M mit $u_{nm} \in \{0, 1\}$, so daß sich der Vektor $\underline{u} = (u_{1I}, \ldots, u_{1M}, \ldots, u_{nm}, \ldots, u_{N1}, \ldots, u_{NM})$ ergibt. Das zeitdiskrete Kanalmodell liefert für jedes Symbol $\hat{u}_{nm}$ einen Schätzwert $g_{nm} = g(\hat{u}_{nm}) = P(\hat{u}_{nm})$ für die Wahrscheinlichkeit, mit der das Symbol $\hat{u}_{nm}$ gesendet wurde. Der Faltungsdecoder soll für jedes decodierte Symbol $\hat{x}_n$ einen Schätzwert $q_n = q(\hat{x}_n)$ für die Wahrscheinlichkeit $P(x_n|\underline{\hat{u}})$ ausgeben, mit der das Symbol $x_n$ gesendet wurde. Zur Vermeidung von Skalierungsproblemen wird als Soft-Output-Wert in der Regel das Wahrscheinlichkeitsverhältnis $\bar{q}_n$ verwendet, wie dies in Gleichung 1 angegeben ist:

$$\bar{q}_n = P(\hat{x}_n = 1 \mid \underline{\hat{u}}) / P(\hat{x}_n = 0 \mid \underline{\hat{u}}) \tag{1}$$

Da der Algorithmus auf faltungscodierte Symbolfolgen angewandt wird. soll kurz auf die Erzeugung derartiger Symbolfolgen eingegangen werden (Faltungsencoder). Bild 2 zeigt die Schaltung eines 1/2-ratigen Faltungsencoders für einen Faltungscode mit der Einflußlänge L (Gedächtnis = L-1). Die Zustände des Faltungscodes, die sowohl im Encoder als auch im Decoder verwendet werden, sollen mit $S_n$ bezeichnet werden und setzen sich aus L-1 vorhergehenden Eingangssymbolen zusammen:

$$S_{n-1} = (X_{n-L+1}, \ldots, X_{n-2}, X_{n-1}) \qquad \text{bzw.} \qquad S_n = (X_{n-L+2}, \ldots, X_{n-1}, X_n)$$

Während des Codiervorganges im Schritt n geht der Encoder vom Ausgangszustand $S_{n-1}$ bei Eingabe des Symbols $x_n$ über in den Folgezustand $S_n$ und gibt dabei das M-stellige Symbol $u_n = (u_{n1}, \ldots, u_{nM})$ aus.

Im folgenden werden die einzelnen Schritte für den exakten Algorithmus, die zur Berechnung der Soft-Output-Werte erforderlich sind, beschrieben.

Im Schritt 1, der die Berechnung der Zweigmetriken betrifft, wird für jeden Zustandsübergang (Zweig), der im Zustand $S_{n-1}$ beginnt und im Zustand $S_n$ endet, aus den geschätzten Wahrscheinlichkeiten $P(\hat{u}_{nm})$ der Empfangssymbole $\hat{u}_{nm}$ die Zweigmetrik $\lambda(S_{n-1}, S_n)$ entsprechend Gleichung 2 berechnet:

$$\lambda(S_{n-1}, S_n) = \prod_{m=1}^{M} P(\hat{u}_{nm}) = \prod_{m=1}^{M} g_{nm}$$

Im Schritt 2 erfolgt die rekursive Berechnung der Rückwärtszustandsmetriken $\Lambda_B(S_n)$ für jeden Schritt n, beginnend mit n = N bis zum Schritt n = L+1 entsprechend Gleichung 3:

$$\Lambda_B(S_{n-1}) = \Lambda_B(S'n) \cdot \lambda(S_{n-1}, S'_n) + \Lambda_B(S''n) \cdot \lambda(S_{n-1}, S''_n)$$

$$\textit{für } n = N, N-1, \ldots, L+1$$

Hierin sind $S'_n$, $S''_n$ Zustände des Faltungsdecoders, die dem Zustand $S_{n-1}$ bei der Rückwärtsrekursion für $x_n = 0$ ($S'_n$) bzw. $x_n = 1$ ($S''_n$) "vorausgehen". Vor Beginn der Rückwärtsrekursion im Schritt n = N müssen die Rückwärtszustandsmetriken $\Lambda_B(S_N)$ mit Startwerten besetzt werden; und zwar $\Lambda_B(S_N = 0)$ mit dem Wert Eins und alle anderen Zustandsmetriken $\Lambda_B(S_N \neq 0)$ mit dem Wert Null. Während der Rückwärtsrekursion werden jeweils in jedem L-ten Schritt die $2^{L-1}$ Rückwärtszustandsmetriken $\Lambda_B(S_n)$ abgespeichert.

Im Schritt 3 erfolgt eine rekursive Berechnung der Vorwärtszustandsmetriken $\Lambda_F(S_n)$ für jeden Schritt n, beginnend mit n = 1 bis zum Schritt n = N entsprechend Gleichung 4:

$$\Lambda_F(S_n) = \Lambda_F(S'_{n-1}) \cdot \lambda(S'_{n-1}, S_n) + \Lambda_F(S''_{n-1}) \cdot \lambda(S''_{n-1}, S_n)$$

$$\textit{für } n = 1, 2, \ldots, N$$

Hierin sind $S'_{n-1}$, $S''_{n-1}$ Zustände des Faltungsdecoders, die dem Zustand $S_n$ bei der Vorwärtsrekursion für $x_{n-L+1} = 0$ ($S'_{n-1}$) bzw. $x_{n-L+1} = 1$ ($S''_{n-1}$) vorausgehen.

Vor Beginn der Vorwärtsrekursion im Schritt n = 1 müssen die Vorwärtszustandsmetriken $\Lambda_F(S_0)$ mit Start-

werten besetzt werden; und zwar $\Lambda_F(S_0 = 0)$ mit dem Wert Eins und alle anderen Zustandsmetriken $\Lambda_F(S_0 \neq 0)$ mit dem Wert Null.

Im Schritt 4 wird die Berechnung der Soft-Output-Werte durchgeführt. Dabei werden während der Vorwärtsrekursion in jedem L-ten Schritt, d.h. für n = L, 2L. 3L, ... usw., die Soft-Output-Werte $\bar{q}_n$ für die vorhergehenden L Symbole $x_n$ bis $x_{n-L+1}$ berechnet; und zwar für die Symbole $x_n$ bis $x_{n-L+2}$ gemäß Glg. (5):

$$\bar{q}_{n-\nu} = \frac{P(\hat{x}_{n-\nu} = 1 \mid \underline{\hat{u}})}{P(\hat{x}_{n-\nu} = 0 \mid \underline{\hat{u}})} = \frac{\sum\limits_{S_n \mid x_{n-\nu} = 1} \Lambda_F(S_n) \cdot \Lambda_B(S_n)}{\sum\limits_{S_n \mid x_{n-\nu} = 0} \Lambda_F(S_n) \cdot \Lambda_B(S_n)} \quad f\ddot{u}r \quad \nu = 0, \; \ldots, \; L-2$$

und für das Symbol $\hat{x}_{n-L+1}$ gemäß Gleichung 6:

$$\bar{q}_{n-L-1} = \frac{P(\hat{x}_{n-L-1} = 1 \mid \underline{\hat{u}})}{P(\hat{x}_{n-L-1} = 0 \mid \underline{\hat{u}})} = \frac{\sum\limits_{S_{n-1} \mid x_{n-L-1} = 1} \Lambda_F(S_{n-1}) \cdot \lambda(S_{n-1}, S_n) \cdot \Lambda_B(S_n)}{\sum\limits_{S_{n-1} \mid x_{n-L-1} = 0} \Lambda_F(S_{n-1}) \cdot \lambda(S_{n-1}, S_n) \cdot \Lambda_B(S_n)}$$

Im folgenden wird der suboptimale Algorithmus beschrieben. Die einzelnen Schritte zur Berechnung der Soft-Output-Werte für den suboptimalen Algorithmus entsprechen denen des exakten Algorithmus, außer daß in den Formeln Wahrscheinlichkeiten durch logarithmierte Wahrscheinlichkeiten oder Log-Likelihood-Verhältniswerte, Multiplikationen durch Additionen und Additionen durch Maximumbildung ersetzt werden müssen.

Im Schritt 1 zur Berechnung der Zweigmetriken wird für jeden Zustandsübergang (Zweig), der im Zustand $S_{n-1}$ beginnt und im Zustand $S_n$ endet, wird aus den Log-Likelihood-Verhältniswerten $g_{nm} = g(\hat{u}_{nm}) = \log(P(\hat{u}_{nm} = 1)/P(\hat{u}_{nm} = 0))$ der Empfangssymbole $\hat{u}_{nm}$, die Zweigmetrik $\lambda(S_{n-1}, S_n)$ entsprechend Gleichung 7 berechnet:

$$\lambda(S_{n-1}, S_n) = \sum_{m=1}^{M} c(\hat{u}_{nm}) \cdot g_{nm} \quad mit \quad \begin{cases} c(\hat{u}_{nm} = 0) = -1 \\ c(\hat{u}_{nm} = 1) = 1 \end{cases}$$

Im Schritt 2 zur Bestimmung der Rückwärtsrekursion erfolgt eine rekursive Berechnung der Rückwärtszu-standsmetriken $\Lambda_B(S_n)$ für jeden Schritt n, beginnend mit n = N bis zum Schritt n = L+1 entsprechend Gleichung 8:

$$\Lambda_B(S_{n-1}) = \max\left(\Lambda_B(S'_n) + \lambda(S_{n-1}, S'_n), \Lambda_B(S''_n) + \lambda(S_{n-1}, S''_n)\right)$$

$$f\ddot{u}r\ n = N, N-1, \ldots, L+1$$

Hierin sind $S'_n$, $S''_n$ Zustände des Faltungsdecoders, die dem Zustand $S_{n-1}$ bei der Rückwärtsrekursion für $x_n = 0$ ($S'_n$) bzw. $x_n = 1$ ($S''_n$) "vorausgehen". Vor Beginn der Rückwärtsrekursion im Schritt n = N müssen die Rückwärtszustandsmetriken $\Lambda_B(S_N)$ mit Startwerten besetzt werden; und zwar $\Lambda_B(S_N = 0)$ mit dem Wert Null und alle anderen Zustandsmetriken $\Lambda_B(S_N \neq 0)$ mit einem großen negativen Wert (z.B. -10 000). Während der Rückwärtsrekursion werden jeweils in jedem L-ten Schritt die $2^{L-1}$ Rückwärtszustandsmetriken $\Lambda_B(S_n)$ abgespeichert.

Im Schritt 3 zur Vorwärtsrekursion erfolgt die rekursive Berechnung der Vorwärtszustandsmetriken $\Lambda_F(S_n)$ für jeden Schritt n entsprechend Gleichung 9, beginnend mit n = 1 bis zum Schritt n = N.

$$\Lambda_F(S_n) = \max\left(\Lambda_F(S'_{n-1}) + \lambda(S'_{n-1}, S_n), \Lambda_F(S''_{n-1}) + \lambda(S''_{n-1}, S_n)\right)$$

$$f\ddot{u}r\ n = 1, 2, \ldots, N$$

Hierin sind $S'_{n-1}$, $S''_{n-1}$ Zustände des Faltungsdecoders, die dem Zustand $S_n$ bei der Vorwärtsrekursion für $x_{n-L+1} = 0$ ($S'_{n-1}$) bzw. $x_{n-L+1} = 1$ ($S''_{n-1}$) vorausgehen. Vor Beginn der Vorwärtsrekursion im Schritt $n = 1$ müssen die Vorwärtszustandsmetriken $\Lambda_F(S_0)$ mit Startwerten besetzt werden; und zwar $\Lambda_F(S_0 = 0)$ mit dem Wert Null und alle anderen Zustandsmetriken $\Lambda_F(S_0 \neq 0)$ mit einem großen negativen Wert (z.B. -10 000).

Im Schritt 4 zur Berechnung der Soft-Output-Werte werden während der Vorwärtsrekursion werden in jedem L-ten Schritt, d.h. für $n = L, 2L, 3L, ...$ usw., die Soft-Output-Werte $\bar{q}_n$ für die vorhergehenden L Symbole $\hat{x}_n$ bis $\hat{x}_{n-L+1}$ berechnet; und zwar für die Symbole $\hat{x}_n$ bis $\hat{x}_{n-L+2}$ gemäß Glg. (10)

$$\bar{q}_{n-v} = \alpha \cdot \log \frac{P(\hat{x}_{n-v} = 1 \mid \hat{u})}{P(\hat{x}_{n-v} = 0 \mid \hat{u})} = \max_{S_n \mid x_{n-v} = 1} (\Lambda_F(S_n) + \Lambda_B(S_n)) \quad \textit{für} \quad v = 0, \ldots, L-2$$
$$- \max_{S_n \mid x_{n-v} = 0} (\Lambda_F(S_n) + \Lambda_B(S_n))$$

und für das Symbol $\hat{x}_{n-L+1}$ gemäß Glg (11).

$$\bar{q}_{n-L-1} = \alpha \cdot \log \frac{P(\hat{x}_{n-L-1} = 1 \mid \hat{u})}{P(\hat{x}_{n-L-1} = 0 \mid \hat{u})} = \max_{S_{n-1} \mid x_{n-L-1} = 1} (\Lambda_F(S_{n-1}) + \lambda(S_{n-1}, S_n) + \Lambda_B(S_n))$$
$$- \max_{S_{n-1} \mid x_{n-L-1} = 0} (\Lambda_F(S_{n-1}) + \lambda(S_{n-1}, S_n) + \Lambda_B(S_n))$$

Hierin ist $\alpha$ eine Proportionalitätskonstante. Die zu decodierenden Binärsymbole $\hat{x}_n$ werden implizit durch das Vorzeichen der Soft-Output-Werte $\bar{q}_n$ repräsentiert:

$$\hat{x}_n = 1 \qquad \text{für } \bar{q}_n \geq 0$$

$$\hat{x}_n = 0 \qquad \text{für } \bar{q}_n < 0$$

Es ist anzumerken, daß beide Algorithmen "symmetrisch" bezüglich der Vorwärts- und Rückwärtsrekursion sind; d.h. es kann zuerst die Vorwärtsrekursion durchgeführt werden mit Abspeicherung der Vorwärtszustandsmetriken in jedem L-ten Schritt, und anschließend die Rückwärtsrekursion mit Berechnung der Soft-Output-Werte.

Im folgenden soll die Kombination des suboptimalen Soft-Output-Algorithmus mit dem herkömmlichen Viterbi-Algorithmus beschrieben werden:

Für den suboptimalen Algorithmus kann man eine weitere Einsparung sowohl an Speicherplatzbedarf als auch an Rechenaufwand erreichen. wenn nur für einen Teil der Bits eines Blockes Soft-Output-Werte erforderlich sind. Diese Bits können dann durch Umsortierung an den Anfang und/oder an das Ende eines Blockes plaziert werden, so daß dann die Möglichkeit besteht, den vollständigen Soft-Output-Algorithmus nur auf diese Bits zu beschränken. Für die übrigen Bits kann die Abspeicherung der akkumulierten Metriken aus der Rückwärtsrekursion und auch die Rückwärtsrekursion selbst entfallen. Statt dessen muß für diese Bits ein "Survivor"- oder Pfad-Gedächtnis während der Vorwärtsrekursion geführt werden, um die Bits decodieren zu können, was dem herkömmlichen Viterbi-Algorithmus entspricht. D.h. die beiden Algorithmen können kombiniert werden, da die Berechnung der akkumulierten Metriken während der Vorwärtsrekursion für beide Algorithmen identisch ist.

Befinden sich die Soft-Output-Bits am Ende eines Blockes, d.h. sollen nur für die letzten $N_L$ Symbole eines Blockes Soft-Output-Werte berechnet werden, so sind folgende Schritte durchzuführen:

1. Durchführung der Rückwärtsrekursion des Soft-Output-Algorithmus für die hinteren $N_L$ Symbole eines Blockes incl. Abspeicherung der Rückwärtszustandsmetriken in jedem L-ten Schritt.

2. Anwendung des herkömmlichen Viterbi-Algorithmus incl. "Survivor"- oder Pfad-Gedächtnis auf die vorderen $N - N_L$ Symbole des Blockes.

3. Durchführung der Vorwärtsrekursion des Soft-Output-Algorithmus für die hinteren $N_L$ Symbole des Blockes incl. Berechnung der Soft-Output-Werte in jedem L-ten Schritt. Dabei benutzt die Vorwärtsrekursion die akkumulierten Metriken aus dem herkömmlichen Viterbi-Algorithmus aus Schritt 2 als Startwerte.

4. Entscheidung der vorderen $N-N_L$ Symbole des Blockes anhand der Kenntnis der hinteren $N_L$ decodierten Symbole und des "Survivor"-Gedächtnisses wie beim herkömmlichen Viterbi-Algorithmus.

Befinden sich die Soft-Output-Bits am Beginn eines Blockes, d.h. sollen nur für die ersten $N_F$ Symbole eines Blockes Soft-Output-Werte berechnet werden, so kann der Umstand ausgenutzt werden, daß der herkömmliche Viterbi-Algorithmus statt durch eine Vorwärtsrekursion ebenfalls durch eine Rückwärtsrekursion realisiert werden kann. Durch Umkehrung der Rekursionsrichtungen gegenüber dem vorhergehenden Fall (Soft-Output-Werte am Ende eines Blockes) ergeben sich dann folgende Schritte:

1. Durchführung der Vorwärtsrekursion des Soft-Output-Algorithmus für die vorderen $N_F$ Symbole eines Blockes incl. Abspeicherung der Vorwärtszustandsmetriken in jedem L-ten Schritt.

2. Anwendung des herkömmlichen Viterbi-Algorithmus (Realisierung durch Rückwärtsrekursion) incl. "Survivor"- oder Pfad-Gedächtnis auf die hinteren $N-N_F$ Symbole des Blockes.

3. Durchführung der Rückwärtsrekursion für die vorderen $N_F$ Symbole des Blockes incl. Berechnung der Soft-Output-Werte in jedem L-ten Schritt. Dabei benutzt die Rückwärtsrekursion die akkumulierten Metriken aus dem herkömmlichen Viterbi-Algorithmus aus Schritt 2 als Startwerte.

4. Entscheidung der hinteren $N-N_F$ Symbole des Blockes anhand der Kenntnis der vorderen $N_F$ decodierten Symbole und des "Survivor"- oder Pfad-Gedächtnisses wie beim herkömmlichen Viterbi-Algorithmus.

Befinden sich die Soft-Output-Bits am Beginn und am Ende eines Blockes, d.h. sollen für die ersten $N_F$ und die letzten $N_L$ Symbole eines Blockes Soft-Output-Werte berechnet werden, so sind folgende Schritte durchzuführen:

1. Durchführung der Rückwärtsrekursion des Soft-Output-Algorithmus für die hinteren $N_L$ Symbole eines Blockes incl. Abspeicherung der Rückwärtszustandsmetriken in jedem L-ten Schritt.

2. Durchführung der Rückwärtsrekursion des Soft-Output-Algorithmus für die vorderen $N_F$ Symbole eines Blockes incl. Abspeicherung der Rückwärtszustandsmetriken in jedem L-ten Schritt. Dabei benötigt die Rückwärtsrekursion einen Vorlauf von ca. 5·L Schritten (ohne Abspeicherung der Metriken), damit bei Erreichen des vorderen Teils sichere Werte für die Rückwärtszustandsmetriken vorliegen.

3. Durchführung der Vorwärtsrekursion des Soft-Output-Algorithmus für die vorderen $N_F$ Symbole des Blockes incl. Berechnung der Soft-Output-Werte in jedem L-ten Schritt.

4. Anwendung des herkömmlichen Viterbi-Algorithmus incl. "Survivor"- oder Pfad-Gedächtnis auf den mittleren Teil des Blockes, bestehend aus $N-N_F-N_L$ Symbolen. Dabei benutzt der herkömmliche Viterbi-Algorithmus die akkumulierten Metriken der Vorwärtsrekursion aus Schritt 3 als Startwerte.

5. Durchführung der Vorwärtsrekursion des Soft-Output-Algorithmus für die hinteren $N_L$ Symbole des Blockes incl. Berechnung der Soft-Output-Werte in jedem L-ten Schritt. Dabei benutzt die Vorwärtsrekursion die akkumulierten Metriken aus dem herkömmlichen Viterbi-Algorithmus aus Schritt 4 als Startwerte.

6. Entscheidung des mittleren Teils des Blockes aus $N-N_F-N_L$ Symbolen anhand der Kenntnis der hinteren $N_L$ decodierten Symbole und des "Survivor"- oder Pfad-Gedächtnisses wie beim herkömmlichen Viterbi-Algorithmus.

Im folgenden wird die Erfindung anhand der in den Figuren dargestellten Ausführungsbeispiele näher beschrieben und erläutert.

Es zeigen:

Fig. 1 ein Ausführungsbeispiel für ein digitales Funkübertragungssystem,

Fig. 2 ein Kanalmodell für ein digitales Funkübertragungssystem,

Fig. 3 ein Ausführungsbeispiel für einen Faltungsencoder,

Fig. 4 ein Diagramm mit Zustandsübergängen,

Fig. 5 Diagramme von BER in Abhängigkeit der Soft-Output-Werte des Faltungsdecoders für a) den exakten und b) den suboptimalen Algorithmus,

Fig. 6 und Fig. 7 jeweils ein Diagramm zur Veranschaulichung der Degradation der Soft-Output-Werte bei unvollständiger Decodierung,

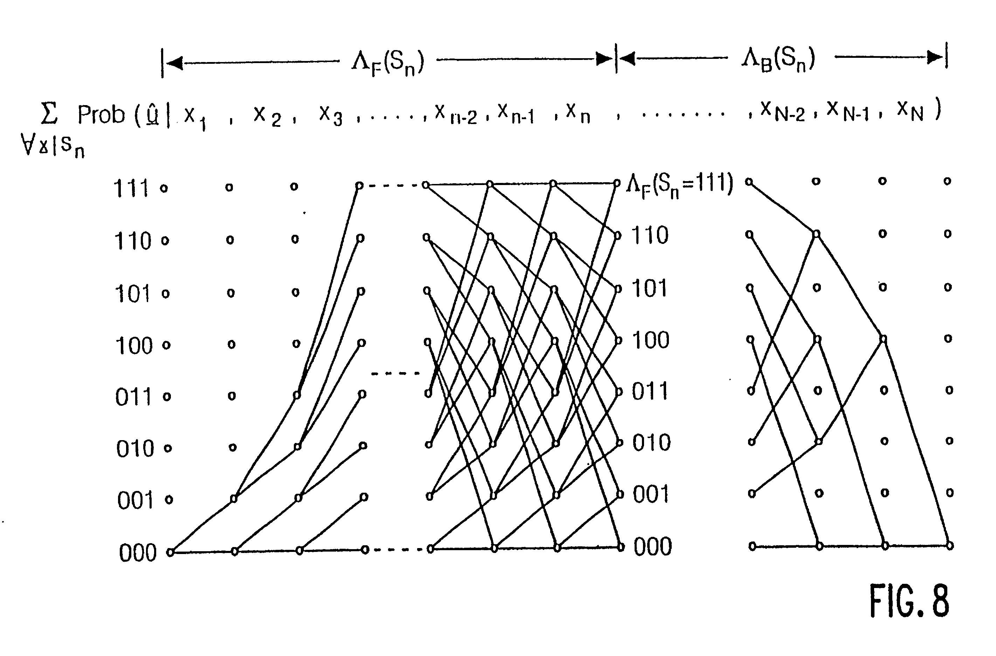

Fig. 8 ein weiteres Diagramm mit Zustandsübergängen,

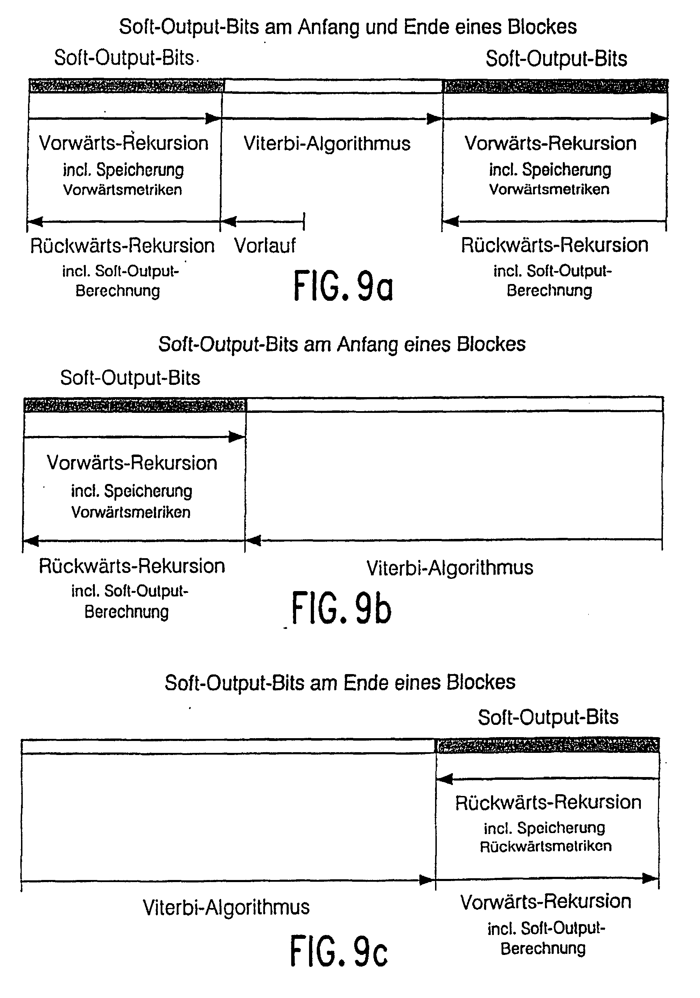

Fig. 9 a) bis c) Darstellungen zur Veranschaulichung der Algorithmen und

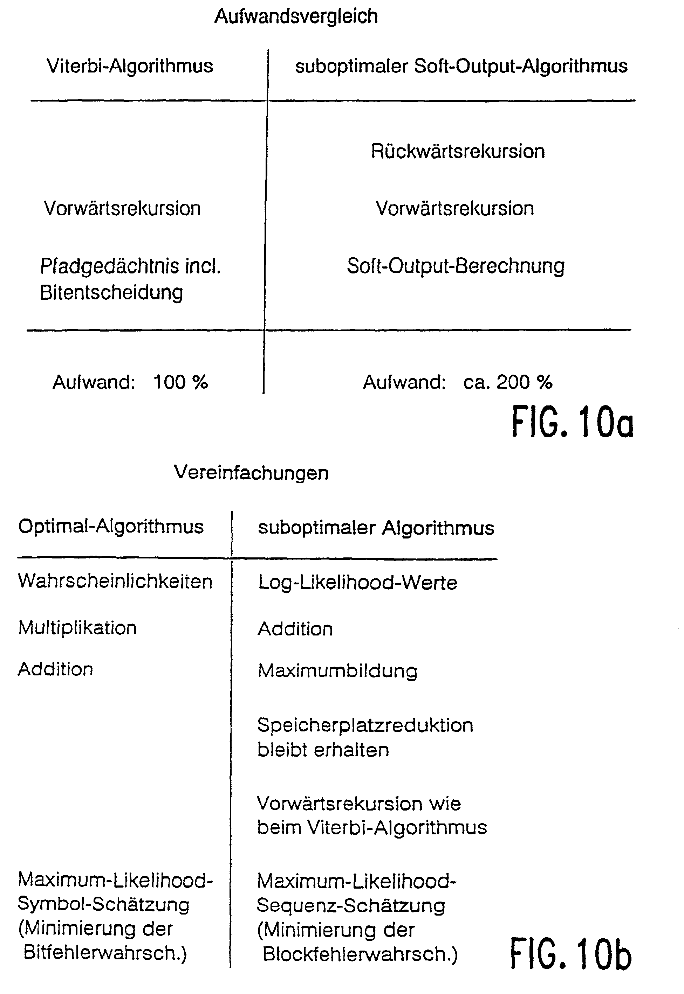

Fig. 10 a), b) eine Gegenüberstellung des Aufwands bzw. der Vereinfachungen.

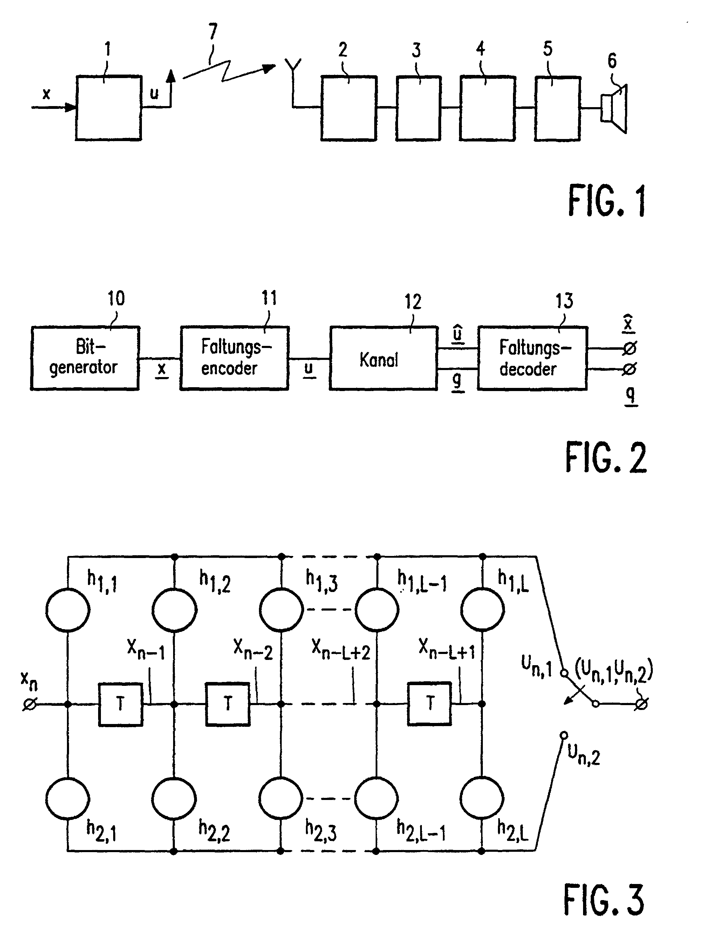

Fig. 1 zeigt ein beispielsweise nach dem GSM-Standard arbeitendes Funkübertragungssystem in Prinzipdarstellung, bei dem ein zu übertragendes Digitalsignal x in Form eines codierten Digitalsignals u von einem Sender, beispielsweise einer Basisstation gesendet wird. Zwischen dem Sender 1 und einem Empfänger 2 liegt eine Funkübertragungsstrecke 7. Der Empfänger weist beispielsweise einen in der Figur nicht näher dargestellten Empfangsteil mit Abtasthalteglied und A/D-Wandler auf. Weiterhin sind auf der Empfangsseite, beispielsweise einer Mobilstation ein Entzerrer 3, eine Decodiereinrichtung 5 (Kanaldecoder), ein Sprach- bzw. Datendecoder 5 sowie ein Lautsprecher 6 vorgesehen. Bei dem in Figur 1 dargestellten Ausführungsbeispiel ist die erfindungsgemäße Decodiereinrichtung auf der beispielsweise durch eine Mobilstation ausgebildete Empfangsseite gezeigt. Die erfindungsgemäße Decodiereinrichtung kann jedoch ebenfalls im Empfänger einer Funkfeststation vorgesehen werden.

Zur Erläuterung des Algorithmus wird ein Übertragungssystem gemäß Fig. 2 betrachtet. Eine Binärquelle 10 erzeugt binäre Vektoren $\underline{x} = (x_1, x_2, ... ,x_{N-L+1}, x_{N\cdot L+2}=0, ... ,x_N=0)$ der Länge N mit $x_i \in \{0, 1\}$, wobei jeweils die letzten L-1 Bits mit Nullen besetzt werden (Tail-Bits), damit der Encoder 11 und Decoder 13 nach jedem Block in den Nullzustand übergehen. Der Faltungsencoder 11 generiert aus jedem Eingabesymbol $x_n$ ein Ausgabesymbol $u_n = (u_{n1}, ... , u_{nM})$ der Länge M mit $u_{nm} \in \{0, 1\}$, so daß sich der Vektor $u = (u_{1I}, ... ,u_{1M}, ... ,u_{nm}, ... ,u_{N1}, ... ,u_{NM})$ ergibt.

Das zeitdiskrete Kanalmodell soll neben dem Übertragungsmedium zusätzlich alle sende- und empfangsseitigen Komponenten wie Modulator, Demodulator und ggf. Entzerrer beinhalten. Es wird angenommen, daß er für jedes Symbol $\hat{u}_{nm}$ einen Schätzwert $g_{nm} = g(\hat{u}_{nm}) = P(\hat{u}_{nm})$ für die Wahrscheinlichkeit liefert, mit der das Symbol $\hat{u}_{nm}$ gesendet wurde. Der Faltungsdecoder soll für jedes decodierte Symbol $x_n$ einen Schätzwert $q_n = q(x_n)$ für die Wahrscheinlichkeit $P(x_n|\underline{\hat{u}})$ ausgeben, mit der das Symbol $x_n$ gesendet wurde. Unter der Annahme eines gedächtnislosen Störprozesses erfüllt der Symbol-by-Symbol MAP-Algorithmus diese Aufgabe in einem optimalen Sinne: d.h. die Bitfehlerwahrscheinlichkeit in der decodierten Ausgangsfolge ist minimal und $1-q_n$ repräsentiert den Schätzwert der Bitfehlerwahrscheinlichkeit für das decodierte Symbol $x_n$.

Der Algorithmus basiert auf der Maximierung der a-Posteriori-Wahrscheinlichkeit für $\hat{x}_n$ unter der Bedingung, daß die Sequenz $\underline{\hat{u}}$ empfangen wurde: d.h. $x_n$ muß für alle n derart gewählt werden, daß gemäß Gleichung 12 gilt:

$$P(\hat{x}_n \mid \underline{\hat{u}}) = \max_{x_n} P(x_n \mid \underline{\hat{u}})$$

Zur Vermeidung von Skalierungsproblemen wird als Soft-Output-Wert in der Regel das Wahrscheinlichkeitsverhältnis $\bar{q}_n$ gemäß Gleichung 13 verwendet:

$$\bar{q}_n = P(\hat{x}_n = 1 \mid \underline{\hat{u}}) / P(\hat{x}_n = 0 \mid \underline{\hat{u}})$$

Bei gleichwahrscheinlichen Binärsymbolen $x_n$ kann Gleichung 13 umgeformt werden in Gleichung 14:

$$\bar{\bar{q}}_n = \frac{P(\hat{x}_n = 1 \mid \underline{\hat{u}})}{P(\hat{x}_n = 0 \mid \underline{\hat{u}})} = \frac{\sum_{\forall \underline{x} \mid x_n = 1} P(\underline{\hat{u}} \mid \underline{x})}{\sum_{\forall \underline{x} \mid x_n = 0} P(\underline{\hat{u}} \mid \underline{x})}$$

Dabei gilt folgende Interpretation: Für jede Position n werden alle möglichen Vektoren $\underline{x}$ durchlaufen, die an der n-ten Position das Symbol $x_n = 1$ besitzen, und für diese Vektoren die Wahrscheinlichkeiten $P(\underline{\hat{u}}|\underline{x})$ gebildet und aufsummiert. Dasselbe wird für $x_n = 0$ wiederholt und aus beiden Summenwahrscheinlichkeiten das Verhältnis gebildet.

Glg. 14 kann für alle Positionen n unter Berücksichtigung der zulässigen Zustandsübergänge des Faltungscodes durch eine Vorwärts- und Rückwärtsrekursion effizient realisiert werden /3,4/. Dabei dienen die Vorwärts- und Rückwärtszustandsmetriken $\Lambda_F(S_n)$ und $\Lambda_B(S_n)$ als Hilfsgrößen, die rekursiv gemäß Glg. 15 berechnet werden können

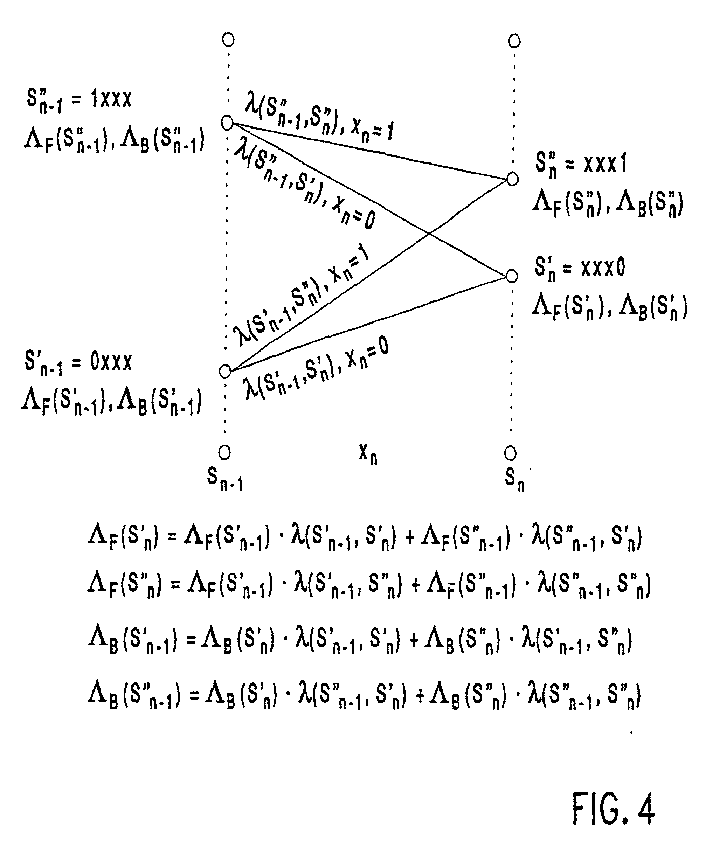

(vgl. Fig. 4).

$$\Lambda_F(S_n) = \Lambda_F(S'_{n-1}) \cdot \lambda(S'_{n-1}, S_n) + \Lambda_F(S''_{n-1}) \cdot \lambda(S''_{n-1}, S_n)$$

$$\Lambda_B(S_{n-1}) = \Lambda_B(S'_n) \cdot \lambda(S_{n-1}, S'_n) + \Lambda_B(S''_n) \cdot \lambda(S_{n-1}, S''_n)$$

Hierin sind $S_n$, $S_{n-1}$     Zustände des Faltungsdecoders im Schritt n bzw. n-1.

$S'_{n-1}$. $S''_{n-1}$     Zustände des Faltungsdecoders, die dem Zustand $S_n$ bei der Vorwärtsrekursion für $x_{n-L+1}= 0$ ($S'_{n-1}$) bzw. $x_{n-L+1} = 1$ ($S''_{n-1}$) vorausgehen.

$S'_n$, $S''_n$     Zustände des Faltungsdecoders, die dem Zustand $S_{n-1}$ bei der Rückwärtsrekursion für $x_n = 0$ ($S'_n$) bzw. $x_n = 1$ ($S''_n$) "vorausgehen".

$\lambda(S_{n-1},S_n)$     Übergangswahrscheinlichkeit (Zweigmetrik) für den Zustandsübergang von $S_{n-1}$ nach $S_n$.

Die Zweigmetriken $\lambda(S_{n-1},S_n)$ ergeben sich dabei aus den Wahrscheinlichkeiten, die z.B. der Entzerrer (hier Teil des Kanals) für die Symbole $u_{nl}, ... ,u_{nM}$ geschätzt hat, die aufgrund der Codiervorschrift zum Zustandsübergang $(S_{n-1},S_n)$ gehören (Gleichung 16):

$$\lambda(S_{n-1}, S_n) = \prod_{m=1}^{M} P(\hat{u}_{nm}) = \prod_{m=1}^{M} g_{nm}$$

Mit Hilfe der Vorwärts- und Rückwärtszustandsmetriken ergeben sich die Soft-Output-Werte $\bar{q}_n$ gemäß Glg. 17:

$$\bar{q}_n = \frac{P(\hat{x}_n = 1 \mid \hat{u})}{P(\hat{x}_n = 0 \mid \hat{u})} = \frac{\sum_{S_n \mid x_n = 1} \Lambda_F(S_n) \cdot \Lambda_B(S_n)}{\sum_{S_n \mid x_n = 0} \Lambda_F(S_n) \cdot \Lambda_B(S_n)}$$

Die Zustände $S_n$ lassen sich in binärer Notation durch die binären Symbole $x_n$ darstellen:

$$S_{n-1} = (x_{n-L+1}, ... , x_{n-2}, x_{n-1}) \qquad \text{bzw.} \qquad S_n = (x_{n-L+2}, ..., x_{n-1}, x_n)$$

Die Summation über alle Zustände $S_n|x_n=1$ bedeutet, daß nur über die Zustände summiert werden soll, die das Symbol $x_n=1$ enthalten. Entsprechendes gilt für $S_n|x_n=0$. Die einzelnen Schritte zur Berechnung der Soft-Output-Werte $\bar{q}_n$ gemäß Glg. 17 sehen also wie folgt aus:

1. Berechnung der Zweigmetriken $\lambda(S_{n-1}, S_n)$ aus den vom Kanal (Entzerrer) geschätzten Wahrscheinlichkeiten $g_{nm}$ der Empfangssymbole $\hat{u}_{nm}$ gemäß Glg. 16.
2. Rekursive Berechnung und Abspeicherung der Rückwärtszustandsmetriken $\Lambda_B(S_n)$ gemäß Glg. 15.
3. Rekursive Berechnung der Vorwärtszustandsmetriken $\Lambda_F(S_n)$ gemäß Glg. (4).
4. Bestimmung der Soft-Output-Werte $\bar{q}_n$ gemäß Glg. 17.

Abgesehen von den numerischen Problemen, die bei der Multiplikation von Wahrscheinlichkeiten auftreten, müssen bei diesem Algorithmus die Rückwärtszustandsmetriken abgespeichert und bis zur Berechnung der Soft-Output-Werte aufgehoben werden; d.h. es müssen dafür $N \cdot 2^{L-1}$ Speicherplätze bereitgehalten werden, wenn N die Blocklänge und L die Einflußlänge des Faltungscodes ist. Zunächst soll gezeigt werden, daß die Rückwärtszustandsmetriken $\Lambda_B(S_k)$ nur in jedem L-ten Schritt abgespeichert werden müssen; d.h. daß der Speicherbedarf um den Faktor L reduziert werden kann. Betrachtet man die Summation in Glg. 17 über $S_n|x_n=1$ und $S_n|x_n=1$ im nächsten Schritt n+1, d.h. versucht man in den Ausdrücken die Größen $\Lambda_F(S_n)$ und $\Lambda_B(S_n)$ durch $\Lambda_F(S_{n+1})$ und $\Lambda_B(S_{n+1})$ zu ersetzen, so kann man durch einige Fleißarbeit zeigen, daß der in der folgenden Gleichung 18 aufgeführte Zusammenhang gilt:

$$\bar{q}_n = \frac{\sum\limits_{S_n \mid x_n = 1} \Lambda_F(S_n) \cdot \Lambda_B(S_n)}{\sum\limits_{S_n \mid x_n = 0} \Lambda_F(S_n) \cdot \Lambda_B(S_n)} = \frac{\sum\limits_{S_{n-1} \mid x_n = 1} \Lambda_F(S_{n-1}) \cdot \Lambda_B(S_{n-1})}{\sum\limits_{S_{n-1} \mid x_n = 0} \Lambda_F(S_{n-1}) \cdot \Lambda_B(S_{n-1})}$$

D.h. durch entsprechende Summation im Schritt n+1 läßt sich nicht nur der Soft-Output-Wert für das aktuelle Symbol $x_{n+1}$ sondern auch für das vorhergende Symbol $x_n$ berechnen. Dieses Ergebnis läßt sich auf die L-2 zurückliegenden Symbole verallgemeinern (Gleichung 19):

$$\bar{q}_{n-v} = \frac{P(\hat{x}_{n-v} = 1 \mid \hat{u})}{P(\hat{x}_{n-v} = 0 \mid \hat{u})} = \frac{\sum\limits_{S_n \mid x_{n-v} = 1} \Lambda_F(S_n) \cdot \Lambda_B(S_n)}{\sum\limits_{S_n \mid x_{n-v} = 0} \Lambda_F(S_n) \cdot \Lambda_B(S_n)} \quad \text{für} \quad v = 0, \ldots, L-2$$

Der Soft-Output-Wert des Symbols $x_{n-L+1}$, das nicht mehr im Zustand $S_n$ jedoch im Zustand $S_{n-1}$ enthalten ist, läßt sich bei der Vorwärtsrekursion im Schritt n wie folgt berechnen (Gleichung 20):

$$\bar{q}_{n-L-1} = \frac{P(\hat{x}_{n-L-1} = 1 \mid \hat{u})}{P(\hat{x}_{n-L-1} = 0 \mid \hat{u})} = \frac{\sum\limits_{S_{n-1} \mid x_{n-L-1} = 1} \Lambda_F(S_{n-1}) \cdot \lambda(S_{n-1}, S_n) \cdot \Lambda_B(S_n)}{\sum\limits_{S_{n-1} \mid x_{n-L-1} = 0} \Lambda_F(S_{n-1}) \cdot \lambda(S_{n-1}, S_n) \cdot \Lambda_B(S_n)}$$

Somit ist durch Glg. 19 und 20 bei der Vorwärtsrekursion im Schritt n die Berechnung von L Soft-Output-Werten ohne zusätzlichen Rechenaufwand möglich. Glg. (9) berechnet zwar indirekt $\Lambda_B(S_{n-1})$ aus $\Lambda_B(S_n)$, jedoch müssen die Zwischengrößen $\Lambda_F(S_{n-1}) \cdot \lambda(S_{n-1}, S_n)$ für die Vorwärtsrekursion ohnehin gebildet werden, so daß der Rechenaufwand genauso groß ist wie in Glg. 19.

Am Rande sei auf einen weiteren interessanten Zusammenhang hingewiesen, der aus Glg. 18 hergeleitet werden kann. Hier besteht nicht nur Gleichheit zwischen beiden Seiten, sondern auch zwischen den Zählern und Nennern beider Seiten, so daß die Addition von Zähler- und Nennergleichung zu dem Ergebnis führt:

$$\sum_{S_n} \Lambda_F(S_n) \cdot \Lambda_B(S_n) = \sum_{S_{n-1}} \Lambda_F(S_{n-1}) \cdot \Lambda_B(S_{n-1}) = C$$

Die Summe aus den Produkten der Vorwärts- und Rückwärtszustandsmetriken ist in jedem Schritt n gleich groß. Es reicht demnach aus, für die Berechnung der Soft-Output-Werte in Glg. 19 und 20 z.B. nur den Zähler zu berechnen. Der Nenner ergibt sich dann aus der Differenz zwischen C und dem Zähler.

Ein Nachteil dieses Algorithmus besteht darin, daß Wahrscheinlichkeiten multipliziert werden müssen, was in der Regel schnell zu numerischen Problemen führt. Diesem Nachteil begegnet man üblicherweise durch Verwendung von Log-Likelihood-Verhältniswerten entsprechend Gleichung 22:

$$g_{nm} = g(\hat{u}_{nm}) = \log \frac{P(U_{nm} = 1)}{P(\hat{u}_{nm} = 0)}$$

Multiplikationen gehen dann über in Additionen. Das Problem der Addition von Wahrscheinlichkeiten ist näherungsweise durch eine Maximumbildung der Logarithmen lösbar; nämlich $\log(P_1 + P_2) \approx \max(\log P_1, \log P_2)$. Der größte Fehler tritt auf für $P_1 = P_2$ und ist betragsmäßig log 2.

Vergleicht man das Operationspaar Addition und Multiplikation mit Maximumbildung und Addition, so stellt man gleiche Rechenregeln fest (Isomorphismus). Insbesondere gilt das assoziative und distributive Gesetz auch für Maximumbildung und Addition.

Verwendet man demnach Log-Likelihood-Verhältnisse statt Wahrscheinlichkeiten, so gelten Glg. 15 bis 21 weiterhin, wenn man die Additionen durch Maximumbildung und die Multiplikationen durch Additionen ersetzt. Die wichtigsten Gleichungen seien an dieser Stelle noch einmal zusammengefaßt.

$$\lambda(S_{n-1}, S_n) = \sum_{m=1}^{M} c(\hat{u}_{nm}) \cdot g_{nm} \quad mit \quad \left| \begin{array}{c} c(\hat{u}_{nm} = 0) = -1 \\ c(\hat{u}_{nm} = 1) = 1 \end{array} \right.$$

$$\Lambda_F(S_n) = \max(\Lambda_F(S'_{n-1}) + \lambda(S'_{n-1}, S_n), \Lambda_F(S''_{n-1}) + \lambda(S''_{n-1}, S_n))$$

$$\Lambda_B(S_{n-1}) = \max(\Lambda_B(S'_n) + \lambda(S_{n-1}, S'_n), \Lambda_B(S''_n) + \lambda(S_{n-1}, S''_n))$$

$$\bar{q}_{n-\nu} = \alpha \cdot \log \frac{P(\hat{x}_{n-\nu} = 1 \mid \hat{u})}{P(\hat{x}_{n-\nu} = 0 \mid \hat{u})} = \max_{S_n \mid x_{n-\nu} = 1} (\Lambda_F(S_n) + \Lambda_B(S_n)) \quad für \quad \nu = 0, \dots, L-2$$

$$- \max_{S_n \mid x_{n-\nu} = 0} (\Lambda_F(S_n) + \Lambda_B(S_n))$$

$$\bar{q}_{n-L-1} = \alpha \cdot \log \frac{P(\hat{x}_{n-L-1} = 1 \mid \hat{u})}{P(\hat{x}_{n-L-1} = 0 \mid \hat{u})} = \max_{S_{n-1} \mid x_{n-L-1} = 1} (\Lambda_F(S_{n-1}) + \lambda(S_{n-1}, S_n) + \Lambda_B(S_n))$$

$$- \max_{S_{n-1} \mid x_{n-L-1} = 0} (\Lambda_F(S_{n-1}) + \lambda(S_{n-1}, S_n) + \Lambda_B(S_n))$$

Hierin ist $\alpha$ eine Proportionalitätskonstante. Auch Glg. (10) gilt entsprechend; d.h. das Maximum der Summe aus Vorwärts- und Rückwärtszustandsmetriken ist in jedem Schritt n gleich groß.

$$\max_{S_n} (\Lambda_F(S_n) + \Lambda_B(S_n)) = \max_{S_{n-1}} (\Lambda_F(S_{n-1}) + \Lambda_B(S_{n-1})) = C$$

Dieses Ergebnis ist sofort einsichtig, wenn man sich vergegenwärtigt, daß der Maximalwert aus Glg. (13) die Summe über alle Zweigmetriken des wahrscheinlichsten Pfades im Trellis-Diagramm darstellt, wobei $\Lambda_F(S_n)$ die ersten n und $\Lambda_B(S_n)$ die letzten N-n Zweigmetriken beinhaltet.

Der Aufwand des beschriebenen Soft-Output-Algorithmus ist etwa doppelt so hoch wie der des klassischen Viterbi-Algorithmus, da das Trellis-Diagramm in Vorwärtsund Rückwärtsrichtung durchlaufen werden muß. Das Pfadgedächtnis und die damit verbundenen Operationen entfallen allerdings vollständig. Dafür kommen einige Operationen für die Berechnung der Soft-Output-Werte hinzu.

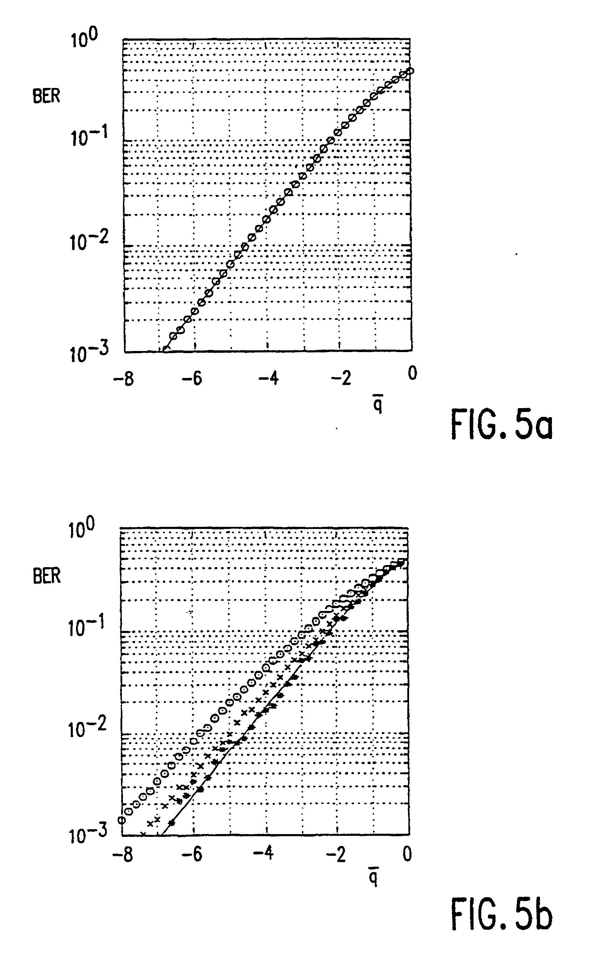

Die Maximumbildung bei Verwendung von Maximum-Likelihood-Verhältniswerten stellt gegenüber dem ursprünglichen Algorithmus eine Näherung dar. Diese Näherung hat keinen spürbaren Einfluß auf die Bitfehlerwahrscheinlichkeit der hart entschiedenen Bits, da die Unterschiede zwischen einer Maximum-Likelihood-Symbol-Schätzung und einer Maximum-Likelihood-Sequenz-Schätzung nicht signifikant sind. Dagegen sind größere Unterschiede bei den Soft-Output-Werten zu erwarten. Zur Klärung dieser Frage diente eine Simulation, in der eine gedächtnislose Bitfehlerquelle zu einer Bitfehlerfolge zusätzlich ideale Soft-Output-Werte $g'_{nm} = \log(p_{nm}/(1-p_{nm}))$ liefert, wobei $p_{nm}$ jeweils die Bitfehlerwahrscheinlichkeit für das Bit $\hat{u}_{nm}$ darstellt. Die Soft-Output-Werte $\bar{q}_n$ des Faltungsdecoders sollen dann die Bitfehlerwahrscheinlichkeiten für die decodierten Bits wiederspiegeln. Fig. 5 zeigt den Verlauf der simulierten Bitfehlerwahrscheinlichkeiten in Abhängigkeit der Soft-Output-Werte (hier Log-Likelihood-Verhältniswerte) des Faltungsdecoders gemeinsam mit der theoretischen Kurve. Während die Bitfehlerwahrscheinlichkeit beim exakten Decodieralgorithmus mit der theoretischen Kurve bis auf kleine statistische Abweichungen übereinstimmt, treten beim suboptimalen Algorithmus insbesondere bei kleinen Signal-Rauschverhältnissen (S/N < 3 dB) systematische Abweichungen von der theoretischen Kurve auf. Ab einem Signal-Rauschverhältnis von ca. 4 dB ist jedoch auch beim suboptimalen Algorithmus eine gute Übereinstimmung mit dem Sollverlauf festzustellen. Diese Qualitätsunterschiede in den Soft-Output-Werten lassen allerdings keinen unmittelbaren Rückschluß auf zu erwartende Verluste bei konkreten Anwendungen zu.

Bei Verwendung der Log-Likelihood-Werte geht der Symbol-by-Symbol MAP-Algorithmus über in eine Maximum-Likelihood-Sequenz-Schätzung; d.h. die aus den Soft-Output-Werten hart entschiedenen Bits sind mit denen des herkömmlichen Viterbi-Algorithmus mit maximalem Pfadgedächtnis identisch. Da die Berechnung der Vorwärtszustandsmetriken für beide Algorithmen identisch ist, eröffnet sich die interessante Möglichkeit, beide Algorithmen zu kombinieren, wenn nur für ausgesuchte Bits Soft-Output-Werte gewünscht werden. So sind z.B. die Bits bei einer Sprachübertragung mit RELP- oder CELP-Codierung unterschiedlich wichtig, was den Gedanken nahelegt, nur für die wichtigsten Bits Soft-Output-Werte zu berechnen. In jedem Fall ist es dann möglich, auf eine Speicherung der Rückwärtszustandsmetriken für den Anteil der hart zu entscheidenden Bits zu verzichten.

Am einfachsten gestaltet sich die Kombination der Algorithmen, wenn die wichtigsten Bits am Ende eines Blockes plaziert werden, wie es z.B. beim jetzigen Stand des GSM-Halbraten-Sprachkanals vorgesehen ist. Dort werden für die letzten codierten 25 Bits eines Sprachblockes von insgesamt 98 codierten Bits Soft-Output-Werte berechnet. In diesem Fall ist es möglich, für die ersten 73 Bits den herkömmlichen Viterbi-Algorithmus (mit harter Entscheidung) zu verwenden, und nur für die letzten 25 Bits den Soft-Output-Algorithmus einzusetzen. Bei einer Einflußlänge von L = 7 ergeben sich dann $64 \cdot \lceil 25/7 \rceil = 256$ Speicherplätze für die Rückwärtsmetriken. Der Rechenaufwand steigt in diesem Fall nur um ca. 30% verglichen mit dem herkömmlichen Viterbi-Algorithmus.

Befinden sich die wichtigsten Bits wie beim Codierschema des GSM-Vollraten-Sprachkanals sowohl am Anfang als auch am Ende eines Blockes. so kann die Rückwärtsrekursion auf den vorderen und hinteren Teil des Blockes beschränkt werden. Für den vorderen Teil muß die Rückwärtsrekursion allerdings etwas früher beginnen (Vorlauf), um bei Erreichen des vorderen Teils zuverlässige Soft-Output-Werte zu erhalten. Es sei darauf hingewiesen, daß die decodierte Ausgangsfolge (Hard-Decision-Bits) und ebenso die Zustandsfolge im Decoder aus der Vorwärtsrekursion bereits bekannt sind. Beim Start der Rückwärtsrekursion wird daher die Startmetrik des Zustandes, der durchlaufen werden soll, zweckmäßigerweise mit dem Wert Null vorbesetzt, während alle anderen Zustandsmetriken einen großen negativen Wert erhalten. Dadurch wird sichergestellt, daß die aus den Soft-Output-Werten decodierte Ausgangsfolge mit der decodierten Ausgangsfolge aus der Vorwärtsrekursion übereinstimmt; d.h. die Bitfehlerwahrscheinlichkeit der Hard-Decision-Bits bleibt durch die unvollständige Soft-Output-Decodierung unverändert.

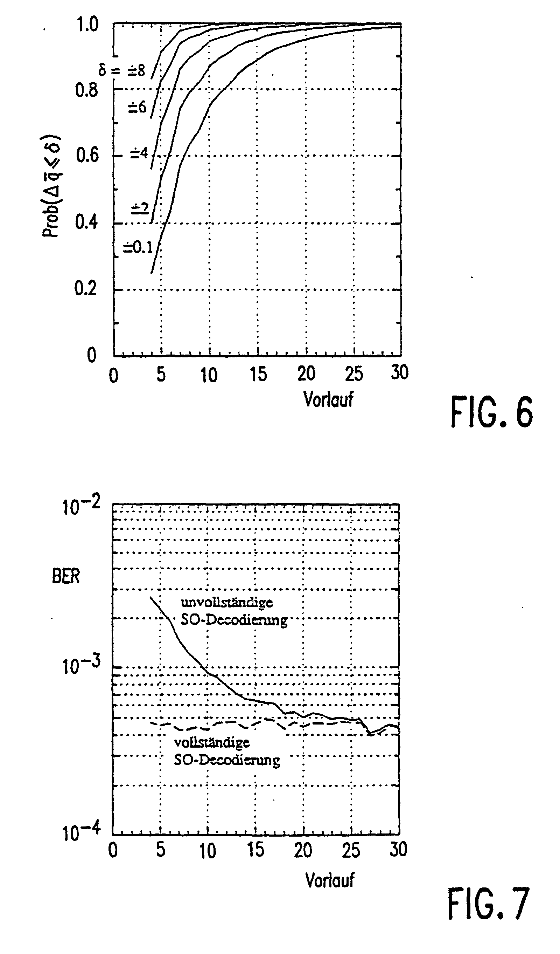

Fig. 6 und 7 veranschaulichen die Degradation der Soft-Output-Werte bei unvollständiger Soft-Output-Decodierung in Abhängigkeit des Vorlaufes, wenn die Rückwärtsrekursion z.B. für den vorderen Teil mitten im Block beginnt. In Fig. 6 stellt $\Delta\bar{q}$ die Abweichung der Soft-Output-Werte zwischen unvollständiger und vollständiger Soft-Output-Decodierung dar. Es zeigt die Wahrscheinlichkeit, daß die Abweichung $\Delta\bar{q}$ innerhalb eines Bereiches von $\pm\delta$ liegt, in Abhängigkeit vom Vorlauf der Rückwärtsrekursion. Der mittlere Soft-Output-Wert beträgt hier 12.44. Dabei stellt die untere Kurve ($\delta = \pm 0.1$) quasi den Fall dar, daß die Soft-Output-Werte übereinstimmen.

Fig. 7 liegt ein System mit äußerem Wiederholungscode und innerem Faltungscode mit Soft-Output-Decodierung zugrunde, wobei ein Multiplex-Schema dafür sorgt, daß die Ausgabebits des Wiederholungsdecoders immer die Bitposition im Codewort des inneren Faltungsdecoders belegen, in der die Soft-Output-Decodierung beginnt. Für diese Anordnung zeigt Fig. 7 die positionsabhängige BER nach dem Wiederholungsdecoder (Soft-Output-Mehrheitsentscheider) in Abhängigkeit des Vorlaufes für die Rückwärtsrekursion.

Der exakte Symbol-by-Symbol MAP-Algorithmus ist aufgrund numerischer Probleme für Festkomma-DSP's grundsätzlich ungeeignet. Dagegen stellt die suboptimale Variante einen leistungsfähigen Soft-Output-Algorithmus dar, der primär für Signalfolgen mit Blockstruktur geeignet ist. Die speicherplatzreduzierte Version erlaubt eine Implementierung des Algorithmus auf heute verfügbaren Standard-DSP's für moderate Blocklängen bis zu einigen hundert Bits. Ferner bietet sich der kombinierte Einsatz mit dem klassischen Viterbi-Algorithmus an, wenn nur für einen Teil des Blockes Soft-Output-Werte erforderlich sind, um weiteren Speicherbedarf und Rechenaufwand einzusparen.

**Patentansprüche**

1.    Digitales Übertragungssystem mit einer eine Codiereinrichtung (11) zur Codierung eines zu übertragenden Digitalsignals (x) aufweisenden Sendeeinrichtung (1), mit mindestens einem Übertragungskanal (7, 12) zur Übertragung des codierten Digitalsignals u und mit einer Decodiereinrichtung (5, 13) zur Bildung eines decodierten Digitalsignals $X$ mit einem den jeweiligen Symbolen $X_n$ des decodierten Digitalsignals $X$ zugeordneten Schätzwert q für die Wahrscheinlichkeit $P(X \mid \hat{U})$, mit der das jeweilige Symbol $X_n$ gesendet wurde, wobei zur Ermittlung der Schätzwerte q Vorwärts- $\Lambda_F(S_n)$ und abzuspeichernde Rückwärtszustandsmetriken $\Lambda_B(S_n)$ vorgesehen sind, wobei mit $S_n$ die Zustände der Faltungscodes bezeichnet werden, die in der Codiereinrichtung (11) und der Decodiereinrichtung (5, 13) verwendet werden,
**dadurch gekennzeichnet,**
**daß** die Decodiereinrichtung (5, 13) Mittel zur Speicherung der Rückwärtszustandsmetriken $\Lambda_B(Sn)$ nur in jedem L-ten Schritt aufweist, wobei L die Einflußlänge des in der Decodiereinrichtung (5, 13) verwendeten Faltungscodes ist.

2.    Übertragungssystem nach Anspruch 1,
**dadurch gekennzeichnet,**
**daß** eine Kombination des Symbol-by-Symbol MAP-Algorithmus und des Viterbi-Algorithmus vorgesehen ist, wo-

# EP 0 737 389 B1

bei nur für die wichtigsten Bits Soft-Output-Werte bestimmt werden.

3. Übertragungssystem nach einem der Ansprüche 1 oder 2,
bei dem vorgesehen ist, die Startmetrik beim Start der Rückwärtsrekursion des zu durchlaufenden Zustandes mit dem Wert Null zu besetzen, während alle anderen Zustandsmetriken einen großen negativen Wert erhalten.

4. Übertragungssystem nach einem der Ansprüche 1 bis 3,
**dadurch gekennzeichnet,**
**daß** die wichtigsten Bits des zu übertragenden Signals sowohl am Anfang als auch am Ende eines Blockes vorgesehen sind und daß eine Beschränkung der Rückwärtsrekursion auf den vorderen und hinteren Teil des Blockes vorgesehen ist.

5. Übertragungssystem nach einem der Ansprüche 1 bis 4,
**dadurch gekennzeichnet,**
**daß** vorgesehen ist, durch entsprechende Summation im Schritt n+1 sowohl für das aktuelle Symbol $x_{n+1}$ als auch für das vorhergende Symbol $x_n$ den Soft-Output-Wert zu bestimmen.

6. Übertragungssystem nach einem der Ansprüche 1 bis 5,
**dadurch gekennzeichnet,**
**daß** durch entsprechende Summation im Schritt n+1 der Soft-Output-Wert sowohl für das aktuelle Symbol $x_{n+1}$ als auch für das vorhergende Symbol $x_n$ bestimmbar ist, wobei eine Verallgemeinerung auf die L-2 zurückliegenden Symbole vorgesehen ist.

7. Funkstation, insbesondere Feststation- oder Mobilstation, mit einer Decodiereinrichtung (5, 13) zur Bildung eines decodierten Digitalsignals $\hat{X}$ aus einem Empfangssignal e mit einem den jeweiligen Symbolen $X_n$ des decodierten Digitalsignals $\hat{X}$ zugeordneten Schätzwert q für die Wahrscheinlichkeit $P(X|\hat{U})$, mit der das jeweilige Symbol $X_n$ gesendet wurde, wobei zur Ermittlung der Schätzwerte q Vorwärts- $\Lambda_F(S_n)$ und abzuspeichernde Rückwärtszustandsmetriken $\Lambda_B(S_n)$ vorgesehen sind, wobei mit $S_n$ die Zustände der Faltungscodes bezeichnet werden, die in der Decodiereinrichtung (5, 13) verwendet werden,
**dadurch gekennzeichnet,**
**daß** die die Decodiereinrichtung (5, 13) Mittel zur Speicherung der Rückwärtszustandsmetriken nur in jedem L-ten Schritt aufweist, wobei L die Einflußlänge des in der Decodiereinrichtung (5, 13) verwendeten Faltungscodes ist.

8. Funkstation nach Anspruch 7,
**dadurch gekennzeichnet,**
**daß** eine Kombimation des Symbol-by-Symbol MAP-Algorithmus und des Viterbi-Algorithmus vorgesehen ist, wobei nur für die wichtigsten Bits Soft-Output-Werte bestimmt werden.

9. Funkstation nach einem der Ansprüche 7 oder 8,
**dadurch gekennzeichnet,**
**daß** vorgeshen ist, beim Start der Rückwärtsrekursion die Startmetrik des zu durchlaufenden Zustandes mit dem Wert Null zu besetzten, während alle anderen Zustandsmetriken einen großen negativen Wert erhalten.

10. Funkstation nach einem der Ansprüche 8 bis 10,
**dadurch gekennzeichnet,**
**daß** die wichtigsten Bits des zu übertragenden Signals sowohl am Anfang als auch am Ende eines Blockes vorgesehen sind und daß die Rückwärtsrekursion auf den vorderen und hinteren Teil des Blockes beschränkt ist.

11. Funkstation nach einem der Ansprüche 8 bis 10,
**dadurch gekennzeichnet,**
**daß** durch entsprechende Summation im Schritt n+1 der Soft-Output-Wert sowohl für das aktuelle Symbol $x_{n+1}$ als auch für das vorhergende Symbol $x_n$ bestimmbar ist.

**Claims**

1. A digital transmission system comprising a transmitting device (1) including a coding device (11) for coding a digital

12

transmit signal (x), comprising at least a transmit channel (7, 12) for transmitting the coded digital signal u and comprising a decoding device (5, 13) for forming a decoded digital signal $x$ via an estimate q assigned to the respective symbols $x_n$ of the decoded digital signal $x$ for the probability $P(x|\hat{u})$ with which the respective symbol $x_n$ was sent, forward state metrics $\Lambda_F(S_n)$ and backward state metrics $\Lambda_B(S_n)$ to be stored being used for calculating the estimates q, where $S_n$ refers to the states of the convolutional codes which are used in the coding device (11) and the decoding device (5, 13), **characterized in that** the decoding device (5, 13) comprises means for storing the backward state metrics $\Lambda_B(S_n)$ only in each $L^{th}$ step, where L is the influence length of the convolutional code used in the decoding device (5, 13).

2. A transmission system as claimed in Claim 1, **characterized in that** a combination of the symbol-by-symbol MAP algorithm and the Viterbi algorithm is made so that soft-output values are calculated only for the most significant bits.

3. A transmission system as claimed in one of the Claims 1 or 2, **characterized in that** at the start of the backward recursion the start metric of the state that is to be passed through obtains the zero value, whereas all the other state metrics obtain a large negative value.

4. A transmission system as claimed in one of the Claims 1 to 3, **characterized in that** the most significant bits of the transmit signal occur both at the beginning and at the end of a block and **in that** the backward recursion is limited to the front and back part of the block.

5. A transmission system as claimed in one of the Claims 1 to 4, **characterized in that** as a result of the respective summation in step n+1 the soft-output value is calculated both for the current symbol $x_{n+1}$ and for the preceding symbol $x_n$.

6. A transmission system as claimed in one of the Claims 1 to 5, **characterized in that** as a result of the respective summation in step n+1 the soft-output value can be calculated both for the current symbol $x_{n+1}$ and for the preceding symbol $x_n$, while there is a generalization for the L-2 previous symbols.

7. A radio station, more particularly a radio base station or mobile station, comprising a decoding device (5, 13) for forming a decoded digital signal $x$ from a received signal e via an estimate q assigned to the respective symbols $x_n$ of the decoded digital signal $x$ for the probability $P(x|\hat{u})$ with which the respective symbol $x_n$ was sent, forward state metrics $\Lambda_F(S_n)$ and backward state metrics $\Lambda_B(S_n)$ to be stored being used for calculating the estimates q, where $S_n$ refers to the states of the convolutional code which are used in the decoding device (5, 13), **characterized in that** the decoding device (5, 13) comprises means for storing the backward state metrics only in each $L^{th}$ step, where L is the influence length of the convolutional code used in the decoding device (5, 13).

8. A radio station as claimed in Claim 7, **characterized in that** a combination of the symbol-by-symbol MAP algorithm and the Viterbi algorithm is used so that the soft-output values are calculated only for the most significant bits.

9. A radio station as claimed in one of the Claims 7 or 8, **characterized in that** at the start of the backward recursion the start metric of the state that is to be passed through obtains the zero value, whereas all the other state metrics obtain a large negative value.

10. A radio station as claimed in one of the Claims 8 to 9, **characterized in that** the most significant bits of the transmit signal occur both at the beginning and at the end of a block and **in that** the backward recursion is limited to the front and back part of the block.

11. A radio station as claimed in one of the Claims 8 to 10, **characterized in that** as a result of the respective summation in step n+1 the soft-output value is calculated both for the current symbol $x_{n+1}$ and for the preceding symbol $x_n$.

## Revendications

1. Système de transmission numérique avec un dispositif de transmission (1) comprenant un dispositif de codage (11) pour coder un signal de transmission numérique (x), avec au moins un canal de transmission (7, 12) pour la transmission du signal numérique u codé et avec un dispositif de décodage (5, 13) pour former un signal numérique décodé (x) par une estimation (q) attribuée aux symboles respectifs ($x_n$) du signal numérique décodé (x) pour la probabilité ($P(x|\hat{u})$) à laquelle le symbole respectif ($x_n$) a été transmis, des mesures d'état postérieur ($\Lambda_F(S_n)$) et

antérieur ($\Lambda_B(S_n)$) à enregistrer étant utilisées pour calculer les estimations (q), **caractérisé en ce que** les mesures d'état antérieur ($\Lambda_B(S_n)$) sont enregistrées seulement dans chaque $L^{me}$ étape, L étant la longueur d'influence du code de convolution utilisé dans le dispositif de décodage (5, 13).

**2.** Système de transmission selon la revendication 1,
**caractérisé en ce**
**qu'**une combinaison de l'algorithme MA symbole par symbole et de l'algorithme de Viterbi est prévue, des valeurs soft-output étant déterminées seulement pour les bits les plus importants.

**3.** Système de transmission selon l'une des revendications 1 ou 2 qui prévoit d'affecter la valeur zéro à la mesure de départ au début de la récursion antérieure de l'état à traverser tandis que toutes les autres mesures d'état reçoivent une valeur négative élevée.

**4.** Système de transmission selon l'une des revendications 1 à 3,
**caractérisé en ce**
**que** les bits les plus importants du signal à transmettre sont prévus à la fois au début et à la fin d'un bloc et qu'une limitation de la récursion antérieure est prévue sur les parties antérieure et postérieure du bloc.

**5.** Système de transmission selon l'une des revendications 1 à 4,
**caractérisé en ce**
**qu'**il est prévu de déterminer la valeur soft-output par l'addition correspondante dans l'étape n+1, à la fois pour le symbole actuel $x_{n+1}$ et pour le symbole précédent $x_n$.

**6.** Système de transmission selon l'une des revendications 1 à 5,
**caractérisé en ce**
**qu'**il est possible de déterminer par addition correspondante dans l'étape n+1 la valeur soft output à la fois pour le symbole actuel $X_{n+1}$ et pour le symbole précédent $x_n$, tandis qu'une généralisation est prévue sur les L-2 symboles précédents.

**7.** Station radio, en particulier station fixe ou station mobile, avec un dispositif de décodage (5, 13) pour former un signal numérique décodé ($\hat{x}$) à partir d'un signal reçu (e) par une estimation (q) attribuée aux symboles respectifs ($x_n$) du signal numérique décodé ($\hat{x}$) pour la probabilité ($P(x|\hat{u})$) à laquelle le symbole respectif ($\hat{x}_n$) a été transmis, des mesures d'état postérieur ($\Lambda_F(S_n)$) et antérieur ($\Lambda_B(S_n)$) à enregistrer étant utilisées pour calculer les estimations (q), **caractérisée en ce que** le dispositif de décodage (5, 13) comprend des moyens pour enregistrer uniquement les mesures d'état antérieur ($\Lambda_B(S_n)$) dans chaque $L^{ème}$ étape, L étant la longueur d'influence du code de convolution utilisé dans le dispositif de décodage (5, 13).

**8.** Station radio selon la revendication 7, **caractérisée en ce qu'**une combinaison de l'algorithme MAP symbole par symbole et de l'algorithme de Viterbi est utilisée de telle sorte que les valeurs soft-output soient calculées uniquement pour les bits les plus importants.

**9.** Station radio selon l'une des revendications 7 ou 8,
**caractérisée en ce**
**qu'**au début de la récursion antérieure, la valeur zéro est attribuée à la mesure de départ de l'état qui doit être traversé tandis que toutes les autres mesures d'état obtiennent une valeur négative élevée.

**10.** Station radio selon l'une des revendications 8 à 9, **caractérisée en ce que** les bits les plus importants du signal de transmission se produisent à la fois au début et à la fin d'un bloc et **en ce que** la récursion antérieure est limitée aux parties antérieure et postérieure du bloc.

**11.** Station radio selon l'une des revendications 8 à 10,
**caractérisée en ce**
**que** la valeur soft output peut être déterminée à la fois pour le symbole actuel $x_{n+1}$ et pour le symbole précédent $x_n$ par addition correspondante dans l'étape n+1.

FIG. 1

FIG. 2

FIG. 3

$$\Lambda_F(S'_n) = \Lambda_F(S'_{n-1}) \cdot \lambda(S'_{n-1}, S'_n) + \Lambda_F(S''_{n-1}) \cdot \lambda(S''_{n-1}, S'_n)$$

$$\Lambda_F(S''_n) = \Lambda_F(S'_{n-1}) \cdot \lambda(S'_{n-1}, S''_n) + \Lambda_{\bar{F}}(S''_{n-1}) \cdot \lambda(S''_{n-1}, S''_n)$$

$$\Lambda_B(S'_{n-1}) = \Lambda_B(S'_n) \cdot \lambda(S'_{n-1}, S'_n) + \Lambda_B(S''_n) \cdot \lambda(S'_{n-1}, S''_n)$$

$$\Lambda_B(S''_{n-1}) = \Lambda_B(S'_n) \cdot \lambda(S''_{n-1}, S'_n) + \Lambda_B(S''_n) \cdot \lambda(S''_{n-1}, S''_n)$$

FIG. 4

FIG.5a

FIG.5b

FIG. 6

FIG. 7

FIG. 8

Soft-Output-Bits am Anfang und Ende eines Blockes

Soft-Output-Bits·

Soft-Output-Bits

Vorwärts-Rekursion
incl. Speicherung
Vorwärtsmetriken

Viterbi-Algorithmus

Vorwärts-Rekursion
incl. Speicherung
Vorwärtsmetriken

Rückwärts-Rekursion
incl. Soft-Output-
Berechnung

Vorlauf

FIG. 9a

Rückwärts-Rekursion
incl. Soft-Output-
Berechnung

Soft-Output-Bits am Anfang eines Blockes

Soft-Output-Bits

Vorwärts-Rekursion
incl. Speicherung
Vorwärtsmetriken

Rückwärts-Rekursion
incl. Soft-Output-
Berechnung

Viterbi-Algorithmus

FIG. 9b

Soft-Output-Bits am Ende eines Blockes

Soft-Output-Bits

Rückwärts-Rekursion
incl. Speicherung
Rückwärtsmetriken

Viterbi-Algorithmus

Vorwärts-Rekursion
incl. Soft-Output-
Berechnung

FIG. 9c

Aufwandsvergleich

| Viterbi-Algorithmus | suboptimaler Soft-Output-Algorithmus |
|---|---|
| | Rückwärtsrekursion |
| Vorwärtsrekursion | Vorwärtsrekursion |
| Pfadgedächtnis incl. Bitentscheidung | Soft-Output-Berechnung |
| Aufwand: 100 % | Aufwand: ca. 200 % |

# FIG. 10a

Vereinfachungen

| Optimal-Algorithmus | suboptimaler Algorithmus |
|---|---|
| Wahrscheinlichkeiten | Log-Likelihood-Werte |
| Multiplikation | Addition |
| Addition | Maximumbildung |
| | Speicherplatzreduktion bleibt erhalten |
| | Vorwärtsrekursion wie beim Viterbi-Algorithmus |
| Maximum-Likelihood-Symbol-Schätzung (Minimierung der Bitfehlerwahrsch.) | Maximum-Likelihood-Sequenz-Schätzung (Minimierung der Blockfehlerwahrsch.) |

# FIG. 10b